# DEMANDE DE BREVET EUROPEEN

(11) **EP 3 764 388 A1**
(43) Date de publication de la demande: **13.01.2021**
(21) Numéro de dépôt: 20184349.7
(22) Date de dépôt: 06.07.2020
(51) Int. Cl.: H01J 37/26, H01J 37/28, G01N 23/20058, G01N 23/2252, G03H 5/00, G01N 23/203, G01N 23/2055

(54) **PROCÉDÉ D'ANALYSE PAR MICROSCOPIE ÉLECTRONIQUE**

(30) Priorité: 08.07.2019 FR 1907615
(71) Demandeur: Commissariat à l'Energie Atomique et aux Energies Alternatives, 75015 Paris (FR)
(72) Inventeur: BERNIER, Nicolas, 38054 GRENOBLE CEDEX 9 (FR); HENRY, Loïc, 83470 SAINT-MAXIMIN-LA-SAINTE-BAUME (FR)
(74) Mandataire: Cabinet Beaumont

(57) **Abrégé**

La présente description concerne un procédé de microscopie électronique, comprenant l'émission d'un faisceau d'électrons (122) animé d'un mouvement de précession (150) et l'acquisition, au moins en partie simultanée, d'une figure de diffraction d'électrons et de valeurs d'intensité de rayons X.

## Description

### Domaine technique

La présente description concerne de façon générale la microscopie électronique, et plus particulièrement un procédé d'analyse d'un objet par microscopie électronique.

### Technique antérieure

La microscopie électronique est utilisée pour analyser divers objets tels que des structures présentes dans des composants électroniques. Des exemples de composants électroniques sont des points mémoire à changement de phase, ou des composants comprenant plusieurs matériaux, par exemple semiconducteurs. Un faisceau d'électrons est focalisé successivement en divers points de l'objet observé. L'analyse peut être une analyse chimique. L'analyse peut aussi être de type cristallographique.

### Résumé de l'invention

Un mode de réalisation pallie tout ou partie des inconvénients des procédés connus d'analyse cristallographique par microscopie électronique.

Un mode de réalisation pallie tout ou partie des inconvénients des procédés connus d'analyse chimique par microscopie électronique.

Un mode de réalisation prévoit un procédé d'analyse chimique et cristallographique d'un objet qui évolue ou bouge au cours de l'analyse.

Un mode de réalisation prévoit un procédé d'analyse chimique et cristallographique particulièrement précis.

Ainsi, un mode de réalisation prévoit un procédé de microscopie électronique, comprenant l'émission d'un faisceau d'électrons animé d'un mouvement de précession et l'acquisition, au moins en partie simultanée, d'une figure de diffraction d'électrons et de valeurs d'intensité de rayons X.

Selon un mode de réalisation, pendant ladite acquisition, le faisceau d'électrons a un axe passant par un point d'un objet.

Selon un mode de réalisation, le procédé comprend une étape parmi :
la détermination que ledit point est situé dans une partie amorphe ; et
la détermination que ledit point est situé dans une partie cristalline.

Selon un mode de réalisation, ledit point correspond à un pixel parmi des pixels d'une image.

Selon un mode de réalisation, le procédé comprend, pour chacun des pixels d'au moins un ensemble de pixels de l'image associés à une phase amorphe, la détermination d'une composition chimique à partir desdites valeurs d'intensité.

Selon un mode de réalisation, le procédé comprend, pour chacun des pixels d'au moins un ensemble de pixels de l'image associés à une même phase cristalline, la détermination d'une composition chimique à partir desdites valeurs d'intensité.

Selon un mode de réalisation, le procédé comprend la détermination de la structure de ladite même phase cristalline et/ou d'un ou plusieurs paramètres de ladite même phase cristalline et/ou d'une orientation de cristal.

Selon un mode de réalisation, le procédé comprend la détermination d'au moins une valeur de déformation à partir de la composition chimique et desdits un ou plusieurs paramètres de ladite même phase cristalline.

Selon un mode de réalisation, le procédé comprend, pour ledit ensemble, la détermination d'une valeur statistique de composition chimique associée aux pixels dudit ensemble.

Selon un mode de réalisation, le mouvement de précession a un même angle et une même fréquence pour tous les pixels de l'image.

Selon un mode de réalisation, le mouvement de précession a un demi-angle au sommet strictement positif et inférieur à 10 degrés.

Selon un mode de réalisation, la fréquence de précession est comprise entre 0,2 et 1000 Hz.

Un autre mode de réalisation prévoit un microscope électronique, configuré pour mettre en oeuvre un procédé tel que défini ci-dessus.

Selon un mode de réalisation, le microscope est à transmission ou à balayage.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en perspective représentant partiellement un microscope électronique configuré pour mettre en oeuvre un procédé selon un mode de réalisation ;

la figure 2 est un chronogramme représentant un exemple de procédé mis en oeuvre par le microscope électronique de la figure 1 ;

la figure 3 représente un exemple d'image obtenue par un exemple du procédé mis en oeuvre par le microscope électronique de la figure 1 ;

la figure 4 représente un exemple de structure analysée dans un exemple de procédé mis en oeuvre par le microscope électronique de la figure 1 ;

la figure 5 représente, en fonction d'une position, des déformations de la structure de la figure 4, obtenues par un exemple du procédé mis en oeuvre par le microscope électronique de la figure 1 ; et

la figure 6 représente, en fonction d'une position, des compositions chimiques de matériaux de la structure de la figure 4, obtenues par un exemple du procédé mis en oeuvre par le microscope électronique de la figure 1.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs électriques, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

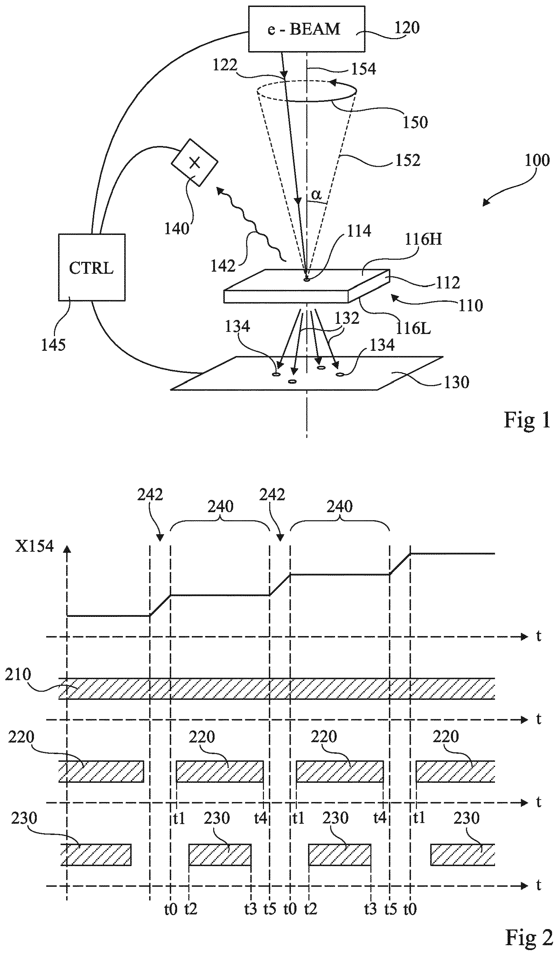

La figure 1 est une vue en perspective représentant partiellement un microscope électronique 100 configuré pour mettre en oeuvre un procédé selon un mode de réalisation.

Le microscope 100 comprend un emplacement 110 destiné à recevoir un objet à observer 112. A titre d'exemple, l'objet à observer 112 est au moins en partie en forme de plaque ayant des faces principales opposées 116H et 116L.

Le microscope électronique 100 comprend en outre un générateur 120 de faisceau électronique (e-BEAM). En fonctionnement, le générateur 120 émet un faisceau d'électrons 122 en direction de l'objet à observer. Les électrons ont typiquement un niveau d'énergie supérieur à 30 keV, de préférence supérieur à 100 keV. Le générateur 120 n'est pas décrit en détail, les modes de réalisation décrits étant compatibles avec les générateurs usuels de faisceaux d'électrons de microscope électronique.

De préférence, le microscope électronique 100 est à transmission. L'objet à observer est en ce cas suffisamment mince pour être traversé par certains des électrons du faisceau, de préférence plus de la moitié des électrons du faisceau. Les modes de réalisation décrits sont compatibles avec les épaisseurs usuelles des objets à observer par microscopie électronique en transmission. Le microscope électronique 100 est alors adapté à détecter des électrons qui ont traversé l'objet. En variante, le microscope électronique est un microscope électronique à balayage, c'est-à-dire adapté à détecter des électrons réfléchis par l'objet, et préférentiellement équipé d'un détecteur pouvant imager les électrons qui ont traversé l'objet.

Le faisceau 122 a un axe passant par un point 114 de l'objet 112, et le faisceau 122 est de préférence focalisé en un point de cet axe. Par exemple, le point 114 est un point de focalisation du faisceau d'électrons. Autrement dit, une zone d'arrivée sur l'objet 112 de sensiblement tous, par exemple de tous, les électrons du faisceau est centrée autour du point 114. Cette zone est par exemple sur la face 116H de l'objet 112. Cette zone est par exemple contenue dans un cercle de diamètre inférieur à 10 nm, de préférence inférieur à 5 nm.

Le microscope 100 comprend en outre un dispositif 130 d'acquisition de figure de diffraction. Plus précisément, le dispositif 130 est configuré pour fournir, ou acquérir et enregistrer, une figure de diffraction d'électrons diffractés 132 par l'interaction du faisceau 122 avec l'objet 112. De préférence, le dispositif 130 d'acquisition de figure de diffraction est situé du côté de l'objet 112 opposé au côté d'arrivée du faisceau 122, c'est-à-dire, dans l'exemple représenté, du côté de la face 116L de l'objet 112. Dans le cas où le faisceau est focalisé au point 114, la figure de diffraction consiste de préférence en une image dont chaque pixel correspond à une direction de diffraction à partir du point 114. Autrement dit, pour chaque pixel, on enregistre un nombre d'électrons diffractés dans une direction donnée. Bien que le faisceau soit de préférence focalisé au point 114, ceci n'est pas limitatif, le faisceau 122 pouvant avoir un plan de focalisation différent de la face 116H. Le dispositif 130 n'est pas décrit en détail, les modes de réalisation décrits étant compatibles avec les dispositifs usuels adaptés à obtenir des figures de diffraction d'électrons. A titre d'exemple, le dispositif 130 comprend une caméra de type dispositif à transfert de charge CCD ("Charge Coupled Device").

Le microscope 100 comprend en outre un détecteur 140 de rayons X, adapté à fournir des valeurs d'intensité de rayons X 142 émis par l'interaction du faisceau d'électrons 122 avec l'objet 112. Chacune des valeurs fournies par le détecteur est représentative d'une intensité des rayons X pour une énergie donnée des rayons X. Les rayons X sont définis par des rayonnements électromagnétiques d'énergie comprise entre 13,6 eV et 300 keV. A titre d'exemple, les valeurs fournies constituent un spectre d'énergie, c'est-à-dire constituent un ensemble de valeurs d'intensité en fonction de l'énergie dans une plage donnée d'énergies. En variante, seules certaines des valeurs du spectre d'énergie sont fournies par le détecteur.

Le microscope 100 comprend en outre une unité de commande 145 (CTRL) reliée, de préférence connectée, au générateur 120 de faisceau d'électrons (ou faisceau électronique), au dispositif 130 d'acquisition de figure de diffraction, et au détecteur 140 de rayons X. L'unité de commande 145 comprend de préférence une unité de traitement de données, telle qu'un ou plusieurs microprocesseurs, et une mémoire. La mémoire contient un programme exécutable par le microprocesseur.

L'exécution du programme par l'unité de traitement met en oeuvre un procédé dans lequel :
- le faisceau d'électrons est animé d'un mouvement de précession 150 ; et
- des périodes d'acquisition d'une figure de diffraction d'électrons et de valeurs d'intensité des rayons X sont au moins en partie simultanées.

Le mouvement de précession 150 est défini par un mouvement au cours duquel l'axe du faisceau 122 parcourt un cône 152, de préférence un cône de révolution. Le cône 152 a un axe 154 et a pour sommet le point 114. L'axe 154 correspond de préférence à l'axe optique du microscope, par exemple orthogonal à la face 116H. De préférence, le cône 152 a un demi-angle au sommet α positif et non nul et au maximum égal à 10 degrés. De préférence, le mouvement de précession a une fréquence comprise entre 0,2 et 1000 Hz.

La période d'acquisition de la figure de diffraction est définie par la période pendant laquelle le dispositif 130 reçoit les électrons diffractés 132 utilisés pour former la figure de diffraction. La figure de diffraction enregistrée/obtenue est composée de disques, d'anneaux ou de points 134. De préférence, le dispositif 130 est placé à une distance suffisante de l'objet 112 afin de couvrir un nombre suffisant de faisceaux diffractés, qui peuvent prendre la forme de points, disques ou anneaux.

La période d'acquisition des valeurs d'intensité des rayons X est définie par la période pendant laquelle le détecteur 140 reçoit les rayons X utilisés pour obtenir ces valeurs d'intensité.

De préférence, on effectue ensuite, à partir de la figure de diffraction et des valeurs d'intensité des rayons X, une analyse chimique et cristallographique de la partie de l'objet 112 ayant interagi avec le faisceau 122.

Plus précisément, l'analyse cristallographique peut consister à déterminer si la partie de l'objet 112 ayant interagi avec le faisceau 122 est amorphe, ou si cette partie est cristalline, c'est-à-dire constituée d'un ou plusieurs cristaux. L'analyse cristallographique peut consister à déterminer la structure cristalline et l'orientation du réseau cristallin dans la partie de l'objet 112 ayant interagi avec le faisceau 122.

Plus précisément, l'analyse chimique peut consister à déterminer la composition chimique de la partie de l'objet 112 ayant interagi avec le faisceau 122. L'analyse chimique peut aussi consister à déterminer des proportions d'éléments chimiques attendus.

Pour effectuer une analyse cristallographique et chimique d'une partie d'un objet, on aurait pu penser obtenir successivement un spectre de rayons X et une figure de diffraction. Cependant, il est courant que l'objet se déplace ou évolue. En particulier, le faisceau d'électrons modifie diverses propriétés structurelles et/ou chimiques de la partie analysée. En outre, des objets tels que des cristaux en formation ou des matériaux à changement de phase peuvent être en évolution. De plus, des vibrations ou divers phénomènes thermiques, en particulier liés au faisceau, sont souvent la source de déplacements de la partie à analyser. Il aurait résulté de ces déplacements ou de cette évolution une imprécision dans les résultats des analyses chimiques et cristallographiques. Des mouvements du faisceau, tels que le mouvement de précession, n'auraient pas permis d'améliorer ce problème de précision.

En comparaison avec une analyse par acquisitions successives d'un spectre d'énergie et d'une figure de diffraction, la simultanéité entre le mouvement de précession, l'acquisition de la figure de diffraction et l'acquisition de valeurs du spectre d'énergie résulte en une analyse plus précise, même lorsque l'objet 112 se déplace, ou évolue.

La figure 2 est un chronogramme représentant un exemple de procédé mis en oeuvre par le microscope électronique de la figure 1. Plus précisément, la figure 2 illustre, en fonction du temps, la position X154 de l'axe 154 du cône de précession, une période 210 au cours de laquelle le faisceau est animé du mouvement de précession 150, des périodes 220 d'acquisition de figure de diffraction, et des périodes 230 d'acquisition de valeurs d'intensité des rayons X.

La position X154 correspond à la position du point 114 de l'objet 112. Le procédé comprend des phases 240 pendant lesquelles la position X154 est fixe. Les phases 240 sont alternées avec des phases 242. Pendant chaque phase 242, le faisceau est déplacé de la position X154 fixe de la phase 240 précédente à la position X154 fixe de la phase 240 suivante. De préférence, la durée de chaque phase 240 à position fixe est supérieure à 0,1 s, par exemple comprise entre 0,5 s et 5 s. La durée de chaque phase 242 de déplacement est de préférence inférieure à 10 ms, plus préférentiellement inférieure à 1 ms. En variante, le faisceau est déplacé instantanément.

De préférence, le faisceau est émis et est animé du mouvement de précession pendant toute la durée des phases 240 et pendant toute la durée des phases 242. Le mouvement de précession a de préférence le même demi-angle au sommet et la même fréquence pour toutes les phases 240.

Chacune des phases 240 à position fixe du faisceau commence à un instant t0. Le dispositif 130 d'acquisition de figure de diffraction est initialisé à un instant t1, égal ou postérieur à l'instant t0.

Dans chaque phase 240, entre des instants t2 et t3, le détecteur 140 détermine des valeurs d'intensité des rayons X. Ensuite, on calcule des valeurs d'intensité moyennes correspondant à la moyenne des valeurs d'intensité des rayons X entre les instants t2 et t3. Pour cela, à titre d'exemple, le détecteur 140 reste en fonctionnement pendant toutes les phases 240 et 242, et les valeurs déterminées résultent d'une différence entre des valeurs d'intensité cumulées mesurées aux instants t3 et t2. En variante, le détecteur 140 est initialisé à l'instant t2.

A un instant t4, le dispositif 130 termine l'acquisition de la figure de diffraction. La phase 240 se termine à un instant t5, égal ou postérieur à l'instant t4.

Dans chacune des phases 240, les acquisitions de la figure de diffraction et des valeurs d'intensité des rayons X sont au moins en partie simultanées, c'est-à-dire qu'au moins une partie des périodes 220 et 230 a lieu en même temps. Autrement dit :
- l'instant t2 de début de la période 230 d'acquisition des valeurs d'intensité des rayons X est antérieur à l'instant t4 de fin de la période 220 d'acquisition de l'image de diffraction ; et
- l'instant t3 de fin de la période 230 d'acquisition des valeurs d'intensité des rayons X est postérieur à l'instant t1 de début de la période 220 d'acquisition de l'image de diffraction.

De préférence, la période 230 d'acquisition des valeurs d'intensité de rayons X a entièrement lieu pendant la période 220 d'acquisition de l'image de diffraction. Autrement dit, les instants t1, t2, t3, t4 et t5 se succèdent dans cet ordre.

La figure de diffraction acquise pendant la période 220 est utilisée à une étape ultérieure, non représentée. A titre d'exemple, si la figure de diffraction n'est pas celle d'un matériau amorphe, on associe à chacun des disques ou anneaux ou points 134 un ensemble d'indices de Miller. Ceci permet d'identifier un état cristallin, par exemple de caractériser la structure cristalline. Des paramètres de la structure cristalline, par exemple des paramètres de maille, ainsi que l'orientation de la structure cristalline, sont déduits des positions des disques ou anneaux ou points 134 dans la figure de diffraction. Les modes de réalisation sont compatibles avec les procédés usuels d'analyse d'une structure cristalline et/ou de son orientation à partir d'une figure de diffraction. Dans la figure de diffraction acquise pendant la période 220, les disques ou anneaux ou points 134 (figure 1) résultant du mouvement de précession permettent une analyse de la structure cristalline plus précise qu'en l'absence de mouvement de précession.

Les valeurs d'intensité des rayons X acquises pendant la phase 230 sont pour des valeurs prédéfinies d'énergie des rayons X. Les valeurs prédéfinies d'énergie peuvent être réparties dans une plage d'énergies. Les rayons X présentent des pics d'intensité à des énergies dépendant de la composition chimique de la partie de l'objet qui interagit avec le faisceau. La plage d'énergie est choisie pour contenir les énergies de ces pics d'intensité. A titre d'exemple, la plage d'énergie est comprise entre 0,1 keV et 20 keV. Par exemple, les valeurs prédéfinies d'énergie sont réparties régulièrement dans la plage avec un pas inférieur à une largeur d'un pic d'intensité. On peut alors déduire une composition chimique à partir des valeurs d'énergie acquises pendant la période 230. Les modes de réalisation décrits sont compatibles avec les procédés usuels d'analyse de composition chimique à partir de valeurs d'intensité de rayons X pour différentes énergies.

De préférence, les valeurs prédéfinies d'énergie des rayons X sont les énergies pour lesquelles le spectre présente des pics correspondant à des éléments chimiques connus à l'avance. Ceci permet de réduire le nombre d'informations à traiter pour l'analyse chimique et donc de simplifier l'analyse. Par exemple, on mesure des proportions, ou pourcentages, de ces éléments connus à l'avance dans les matériaux analysés.

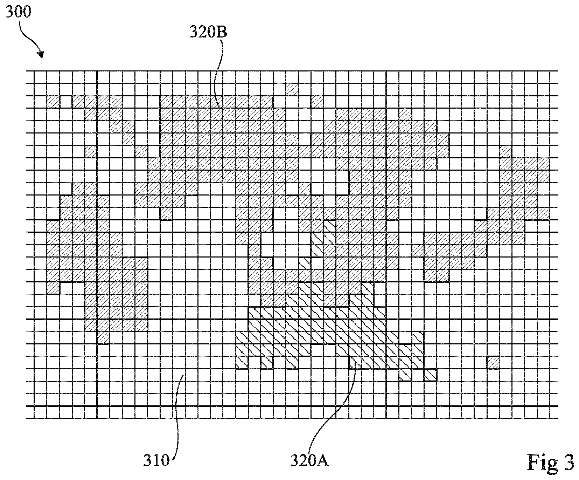

La figure 3 représente un exemple d'image 300 obtenue par un exemple du procédé mis en oeuvre par le microscope électronique de la figure 1.

Plus précisément, le procédé correspond à celui de la figure 2, dans lequel chacune des positions successives X154 de l'axe de précession du faisceau est associée à un pixel de l'image. Ainsi, chaque position X154 correspond à un point 114 de l'objet observé 112. L'image correspond à la cartographie d'une zone d'intérêt de l'objet 112. En variante, la zone d'intérêt est placée en bord de l'objet, et seule une partie des positions X154 correspondent à des points de l'objet.

La zone d'intérêt est sélectionnée préalablement à la mise en oeuvre du procédé. On met ensuite en oeuvre une étape de calibration des distances entre positions X154 successives, permettant de définir les positions X154 disposées en matrice dans l'ensemble de la zone d'intérêt.

Dans l'exemple représenté, la zone d'intérêt est comprise dans un matériau à changement de phase d'une cellule mémoire. On programme une telle cellule en rendant amorphe une partie initialement cristalline du matériau à changement de phase. La lecture de l'information contenue dans la cellule mémoire est basée sur une différence de conductivité électrique entre les états cristallin et amorphe. Le matériau à changement de phase est ici à base de germanium, d'antimoine et de tellure.

On définit des ensembles 320A, 320B de pixels 310 de l'image 300. Les ensembles 320A et 320B sont représentés en figure 3 par des hachures différentes. L'exemple représenté de deux ensembles n'est pas limitatif, le nombre d'ensembles pouvant être inférieur ou supérieur à deux. Les pixels de l'ensemble 320A correspondent aux points 114 (figure 1) situés dans une région amorphe de l'objet, c'est-à-dire dans une phase amorphe. Les pixels de l'ensemble 320B correspondent aux positions de points 114 où l'objet présente un même état cristallin, c'est-à-dire a une même structure cristalline. En d'autres mots, les pixels de l'ensemble 320B correspondent à une région cristalline dans laquelle l'objet présente une même phase cristalline. La structure cristalline correspondant à l'ensemble 320B peut être polycristalline, c'est-à-dire comprendre plusieurs orientations de cristaux. En variante, on définit des ensembles 320A, 320B dont les pixels correspondent à des structures cristallines différentes, ce qui permet de visualiser les cristaux. En deuxième variante, on définit chaque ensemble 320A, 320B par les pixels correspondant à un même état cristallin avec des orientations de cristaux différentes. Les pixels de chaque ensemble 320A, 320B peuvent être contigus ou non.

On détermine alors la composition de chaque ensemble. A titre d'exemple, on définit une composition moyenne de la phase correspondant à cet ensemble. De manière similaire, on peut déterminer pour chaque ensemble toute valeur statistique telle que la moyenne, le minimum, le maximum ou l'écart type du pourcentage d'un ou plusieurs des éléments chimiques constituant la phase correspondant à l'ensemble.

Pour chaque ensemble, on a ainsi déterminé l'état parmi des états amorphe et cristallin, et on a analysé la phase amorphe ou la phase cristalline. La simultanéité entre le mouvement de précession, l'acquisition de la figure de diffraction et l'acquisition de valeurs du spectre d'énergie permet d'éviter qu'à la suite d'un déplacement, d'une déformation ou d'une évolution, les éléments chimiques présents autour de la phase analysée influent sur les résultats de l'analyse chimique, et/ou que la structure cristalline présente autour de la phase analysée influe sur les résultats de l'analyse cristallographique.

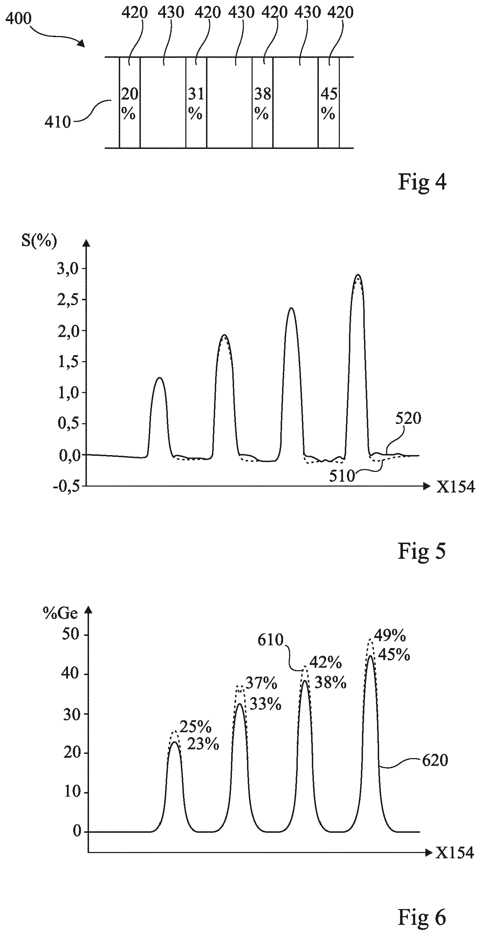

La figure 4 représente un exemple d'un objet 400 analysé dans un exemple du procédé de la figure 2.

L'objet 400 est par exemple une structure obtenue par épitaxie de couches alternées 420 et 430 respectivement en silicium-germanium et en silicium, sur une région 410 en silicium monocristallin. A titre d'exemple, la structure 400 comprend quatre couches 420 de silicium-germanium. Les couches 420 sont plus fines que les couches 430 de silicium. Les couches 420 de silicium-germanium ont une épaisseur de l'ordre de 15 nm. Les réseaux cristallins, plus particulièrement les réseaux cristallins des couches 420, sont déformés en raison du désaccord de maille entre le silicium et le silicium-germanium. Les couches 420 comprennent des pourcentages de germanium respectivement égaux à 20 %, 31 %, 38 % et 45 % (en partant de la région 410) .

La figure 5 représente, en fonction de la position X154 (figure 2), des déformations S, en pourcentage (%), de la structure de la figure 4, obtenues par un exemple du procédé de la figure 2. Plus précisément, on a représenté, pour chaque position X154, en pointillés, des valeurs de déformation 510 calculées à partir de la composition chimique déterminée par l'analyse selon le procédé, et, en traits pleins, des valeurs de déformation 520 obtenues à partir des paramètres cristallins déterminés par l'analyse selon le procédé. Les valeurs de déformation 510 et 520 diffèrent de moins de 0,1 %.

La figure 6 représente des compositions chimiques de matériaux de la structure de la figure 4, obtenues par un exemple du procédé de la figure 2. Plus précisément, on a représenté, pour chaque position X154, en pointillés, des valeurs de pourcentage 610 de germanium (%Ge) obtenues par un procédé sans mouvement de précession, et, en traits pleins, des valeurs de pourcentage 620 obtenues par le procédé de la figure 2. Les différences entre les pourcentages de germanium de la structure 400 et les valeurs maximales mesurées avec mouvement de précession, respectivement de 23 %, 33 %, 38 % et 45 %, sont inférieures à 3 %. En outre, les valeurs maximales mesurées avec mouvement de précession sont plus précises que celles, respectivement de 25 %, 37 %, 42 % et 49 %, obtenues sans mouvement de précession.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

Enfin, la mise en oeuvre pratique des modes de réalisation et variantes décrits est à la portée de l'homme du métier à partir des indications fonctionnelles données ci-dessus.

## Revendications

1. Procédé de microscopie électronique, comprenant l'émission d'un faisceau d'électrons (122) animé d'un mouvement de précession (150) et l'acquisition, au moins en partie simultanée, d'une figure de diffraction d'électrons et de valeurs d'intensité de rayons X.

2. Procédé selon la revendication 1, dans lequel, pendant ladite acquisition, le faisceau d'électrons (122) a un axe passant par un point (114) d'un objet (112).

3. Procédé selon la revendication 2, comprenant une étape parmi :
la détermination que ledit point est situé dans une partie amorphe ; et
la détermination que ledit point est situé dans une partie cristalline.

4. Procédé selon la revendication 2 ou 3, dans lequel ledit point correspond à un pixel (310) parmi des pixels d'une image (300).

5. Procédé selon les revendications 3 et 4, comprenant, pour chacun des pixels d'au moins un ensemble (320A) de pixels de l'image (300) associés à une phase amorphe, la détermination d'une composition chimique à partir desdites valeurs d'intensité.

6. Procédé selon les revendications 3 et 4, comprenant, pour chacun des pixels (310) d'au moins un ensemble (320B) de pixels de l'image (300) associés à une même phase cristalline, la détermination d'une composition chimique à partir desdites valeurs d'intensité.

7. Procédé selon la revendication 6, comprenant la détermination de la structure de ladite même phase cristalline et/ou d'un ou plusieurs paramètres de ladite même phase cristalline et/ou d'une orientation de cristal.

8. Procédé selon la revendication 7, comprenant la détermination d'au moins une valeur de déformation (510, 520) à partir de la composition chimique et desdits un ou plusieurs paramètres de ladite même phase cristalline.

9. Procédé selon l'une quelconque des revendications 5 à 8, comprenant, pour ledit ensemble, la détermination d'une valeur statistique de composition chimique associée aux pixels dudit ensemble.

10. Procédé selon l'une quelconque des revendications 4 à 9, dans lequel le mouvement de précession (150) a un même angle et une même fréquence pour tous les pixels (310) de l'image (300).

11. Procédé selon l'une quelconque des revendications 1 à 10, dans lequel le mouvement de précession (150) a un demi-angle au sommet (α) strictement positif et inférieur à 10 degrés.

12. Procédé selon l'une quelconque des revendications 1 à 11, dans lequel la fréquence de précession est comprise entre 0,2 et 1000 Hz .

13. Microscope électronique, configuré pour mettre en oeuvre un procédé selon l'une quelconque des revendications 1 à 12.

14. Microscope selon la revendication 13, à transmission ou à balayage.
